# EUROPEAN PATENT APPLICATION

(11) **EP 3 745 261 A1**
(43) Date of publication of application: **02.12.2020**
(21) Application number: 18724116.1
(22) Date of filing: 23.03.2018
(51) Int. Cl.: G06F 9/48

(54) **DISPLAY APPARATUS, ELECTRONIC DEVICE, AND SCREEN DISPLAY CONTROL METHOD**

(30) Priority: 26.01.2018 CN 201810077535
(71) Applicant: Mobvoi Information Technology Company Limited, Beijing (CN)
(72) Inventor: CAO, Huanjie, Beijing (CN); PENG, Saihuang, Beijing (CN)
(74) Representative: Cabinet Beau de Loménie
(86) International application number: PCT/CN2018/080294
(87) International publication number: WO 2019/144488

(57) **Abstract**

Provided is a display device. The display device includes: a display screen and at least two controllers, at least two types of operating systems respectively run on the at least two controllers, the at least two controllers are respectively connected to the display screen through at least two types of interfaces, and the at least two controllers each is configured to, in a respective operating state, control the display screen to display.

## Description

The present application is proposed based on and claims the priority of the Chinese patent application No. 201810077535.7 filed on January 26, 2018, the entirety of which is herein incorporated by reference.

### TECHNICAL FIELD

The present disclosure relates to the technology of electronic device. The present disclosure relates to for example a display device, an electronic device and a method of controlling screen display.

### BACKGROUND

With the rapid development of electronic devices, small wearable electronic devices with a screen such as smartwatches and smart bracelets get more and more attention of users. A user may use a small wearable electronic device to implement various functions through a connection between a built-in intelligent system or an operating system on a smartphone and the network. For example, the user can use the small wearable electronic device to synchronize phone numbers, short messages, emails, photos and music in the phone.

The most of existing small wearable electronic devices uses a single system to drive the screen to display.

Therefore, when the screen of an electronic device displays, the operating system of the electronic device needs to stay in an operating state. When the operating system of the electronic device is complex, the display screen cannot be controlled flexibly.

### SUMMARY

The followings is the summary of the subject matter which will be described herein in detail. The summary is not intended to limit the protection scope of the claims.

In view of the above, the present disclosure provides a display device, an electronic device and a method of controlling screen display, which not only satisfies the requirements on display but also allows to control the display screen flexibly.

In an embodiment, a display device is provided, which includes a display screen and at least two controllers,
at least two types of operating systems respectively run on the at least two controllers, the at least two controllers are respectively connected to the display screen through at least two types of interfaces, and the at least two controllers each is configured to, in a respective operating state, control the display screen to display.

In an embodiment, the controller includes a master controller and a slave controller,
a master operating system runs on the master controller, a slave operating system runs on the slave controller, and power consumption of the slave operating system is lower than power consumption of the master operating system.

In an embodiment, the master operating system includes an Android operating system (Android OS), and the slave operating system includes a real-time operating system (RTOS).

In an embodiment, the master controller is connected to the display screen through a mobile industry processor interface (MIPI), the slave controller is connected to the display screen through a serial peripheral interface (SPI) or an inter-integrated circuit (I2C) interface.

In an embodiment, the master controller is connected to the slave controller,
the master controller is configured to trigger the slave controller to enter an operating state when the master controller switches from the operating state to a hibernating state and to trigger the slave controller to enter the hibernating state when the master controller switches from the hibernating state to the operating state.

In an embodiment, the display screen includes an organic light emitting display panel and a touch screen covering the organic light emitting display panel.

In an embodiment, an electronic device is provided, which includes a display device provided by the embodiments of the present disclosure.

In an embodiment, a method of controlling screen display is further provided, which includes: when a master controller switches from an operating state to a hibernating state, using the master controller to stop controlling a display screen to display and trigger a slave controller to enter the operating state; and
when the master controller switches from the hibernating state to the operating state, using the master controller to start controlling the display screen to display and trigger the slave controller to enter the hibernating state,
wherein when the slave controller switches from the hibernating state to the operating state, the slave controller stops controlling the display screen to display, and when the slave controller switches from the operating state to the hibernating state, the slave controller starts controlling the display screen to display.

In an embodiment, the step of using the master controller to stop controlling the display screen to display comprises: using the master controller to close a display driver of the master controller,
the step of using the master controller to start controlling the display screen to display comprises: using the master controller to open the display driver of the master controller.

In an embodiment, after the master controller triggers the slave controller to enter the operating state, the method further includes:
using the master controller to send basic information to be displayed to the slave controller, wherein the basic information to be displayed is information displayed by the display screen in the control of the slave controller after the slave controller enters the operating state,
wherein the basic information to be displayed includes at least one of the followings: system time, system date, and data on vital signs.

The present disclosure provides a display device, an electronic device and a method of controlling screen display. Different types of operating systems run on different controllers, and the controllers switch their states according to the requirements on the display device and control the display screen to display. This addresses the problem in the related art that, in the case where the operating system is the only system for driving the screen to display and is complex, the operating system of the display device needs to stay in the operating state and the display screen cannot be controlled flexibly, thereby achieving the effects of satisfying the requirements on display and flexibly controlling the display screen.

Other aspects of the present disclosure can be understood after reading and understanding the drawings and the detailed description.

### BRIEF DESCRIPTION OF DRAWINGS

Fig. 1 is a structure diagram of a display device provided by an embodiment 1;
Fig. 2 is a structure diagram of a display device provided by an embodiment 2;
Fig. 3 is a structure diagram of a display device provided by an embodiment 3;
Fig. 4 is a structure diagram of a display device provided by the embodiment 3;
Fig. 5 is a flow chart of a method of controlling screen display provided by an embodiment 4;
Fig. 6 is a structural block diagram of a device of controlling screen display provided by an embodiment 5; and
Fig. 7 is a structure diagram of an electronic device provided by an embodiment 7.

### DETAILED DESCRIPTION

### Embodiment 1

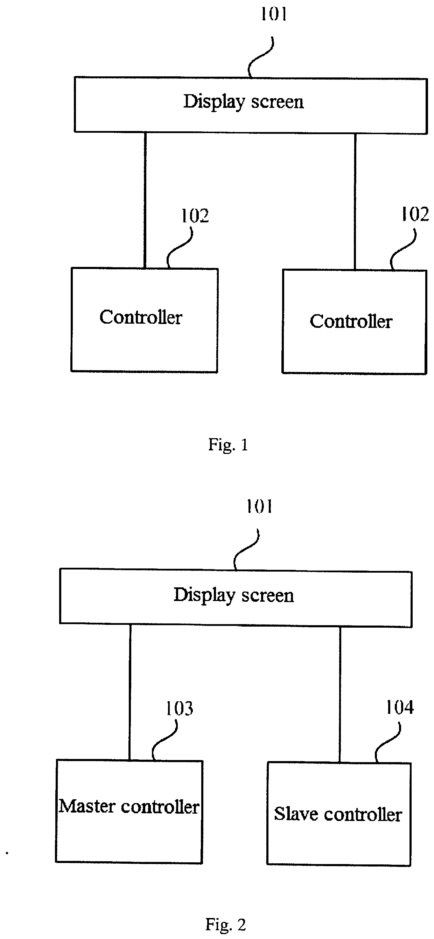

Fig. 1 is a structure diagram of a display device provided by an embodiment 1. The embodiment can satisfy the requirements on display and control the display screen flexibly. As shown in Fig. 1, the display device includes a display screen 101 and at least two controllers 102.

Different types of operating systems run on the at least two controllers 102 and have different power consumption.

The at least two controllers 102 are respectively connected to the display screen 101 through at least two types of interfaces, and the at least two controllers 102 each is configured to, in a respective operating state, control the display screen 101 to display.

Different types of operating systems run on different controllers 102 and have different power consumption. In an embodiment, the operating systems include an Android OS and a RTOS. The power consumption of the RTOS is lower than the power consumption of the Android OS. The power consumption of the controller 102 on which the RTOS runs is lower than the power consumption of the controller 102 on which the Android OS runs.

The at least two controllers 102 are respectively connected to the display screen 101 through different types of interfaces. Optionally, the interfaces include: a mobile industry processor interface (MIPI), a serial peripheral interface (SPI), or an inter-integrated circuit (I2C) interface. Each controller 102 may be connected to the display screen 101 through the MIPI, or may be connected to the display screen 101 through the SPI or the I2C interface.

The at least two controllers 102 each in a respective operating state controls the display screen 101 to display. The states of the at least two controllers 102 include operating state and hibernating state. The at least two controllers 102 switch their states according to the requirements of the display device and control the display screen 101 to display. In an embodiment, when the controller 102 on which the operating system with high power consumption switches from the operating state to the hibernating state, this controller 102 stops controlling the display screen 101 to display. At the same time, the controller 102 on which the operating system with low power consumption runs switches from the hibernating state to the operating state and starts controlling the display screen 101 to display. When the controller 102 on which the operating system with high power consumption runs switches from the hibernating state to the operating state, this controller 102 starts controlling the display screen 101 to display. At the same time, the controller 102 on which the operating system with low power consumption runs switches from the operating state to the hibernating state and stop controlling the display screen 101 to display. Based on the requirements of the display device, the multiple controllers 102 switch their states. Therefore, the controller 102 on which the operating system with high power consumption runs does not stay in the operating state, reducing the consumption of the battery power and extending the stand-by time of the display device. Optionally, the display screen 101 includes an organic light emitting display panel and a touch screen covering the organic light emitting display panel.

The controllers 102 in respective operating states control the organic light emitting display panel and the touch screen covering the organic light emitting display panel to display.

In an embodiment, the touch screen is configured to acquire touch-position information and send the touch-positon information to a specific controller (e.g., the master controller) or a controller which is currently in the operating state. The touch screen can implement the interaction between the user and the display device, making it more convenient for the user to operate the display screen.

In another optional embodiment, the display screen 101 includes an organic light emitting display panel and a transparent glass covering the organic light emitting display panel. The transparent glass arranged in the display screen 101 can effectively protect the organic light emitting display panel.

For the display device provided by the present embodiment, different types of operating systems run on respective controllers, the controllers switch states according to the requirement on the display device and control the display screen to display. This addresses the problem in the related art that, in the case where the operating system is the only system for driving the screen to display and is complex, the display screen cannot be controlled flexibly, thereby achieving the effects of satisfying the requirements on display and flexibly controlling the display screen.

### Embodiment 2

Fig. 2 is a structure diagram of a display device provided by an embodiment 2. This embodiment is formed by modifying the embodiment described above. As shown in Fig. 2, the controllers include a master controller 103 and a slave controller 104.

A master operating system runs on the master controller 103. A slave operating system runs on the slave controller 104. The power consumption of the slave operating system is lower than the power consumption of the master operating system.

The master controller 103 and the slave controller 104 each, in a respective operating state, controls the display 101 to display. The states of the master controller 103 and the slave controller 104 include operating state and hibernating state. The master controller 103 and the slave controller 104 switch their states according to the requirements of the display device and control the display screen 101 to display. In an embodiment, when the master controller 103, on which the master operating system runs, switches from the operating state to the hibernating state, the master controller 103 stop controlling the display screen 101 to display. At the same time, the slave controller 104, on which the slave operating system runs, switches from the hibernating state to the operating state and starts controlling the display screen 101 to display. On the contrary, when the master controller 103, on which the master operating system runs, switches from the hibernating state to the operating state, the master controller 103 starts controlling the display screen 101 to display. At the same time, the slave controller 104, on which the slave operating system runs, switches from the operating system to the hibernating system and stops controlling the display screen 101 to display. Based on the requirements of the display device, the master controller 103 and the slave controllers 104 switches their states. Therefore, the master controller 103, on which the master operating system runs, does not stay in the operating state, reducing the consumption of the battery power and extending the stand-by time of the display device.

Optionally, the master operating system is Android OS, and the slave operating system is RTOS. The power consumption of the RTOS is lower than the power consumption of the Android OS. The power consumption of the slave controller 104 on which the RTOS runs is lower than the power consumption of the master controller 103 on which the Android OS runs.

Optionally, the master controller 103 is connected to the display screen 101 through the MIPI, the slave controller 104 is connected to the display screen 101 through the SPI or the I2C interface.

The master controller and the slave controller control the display screen with different interfaces, such that the isolation between control instructions is improved and the interference is reduced. In general, the SPI and the I2C interface are low speed interfaces. The date transmission rate of the SPI and the I2C interface is less than that of the MIPI. However, since the slave controller generally operates when the master controller is in a stand-by state, the slave controller controls the display screen to display a small amount of data. As such, the SPI or I2C interface can satisfy the actual requirements.

For the display device provided by the embodiment, operating systems with different power consumption respectively run on the master controller and the slave controller, the master controller and the slave controller switch their states according to the requirements of the display device, and control the display screen to display. This addresses the problem in the related art that, in the case where the operating system is the only system for driving the screen to display and is complex, the operating system of the display device needs to stay in the operating state and the display screen cannot be controlled flexibly, thereby achieving the effects of satisfying the requirements on display and flexibly controlling the display screen.

### Embodiment 3

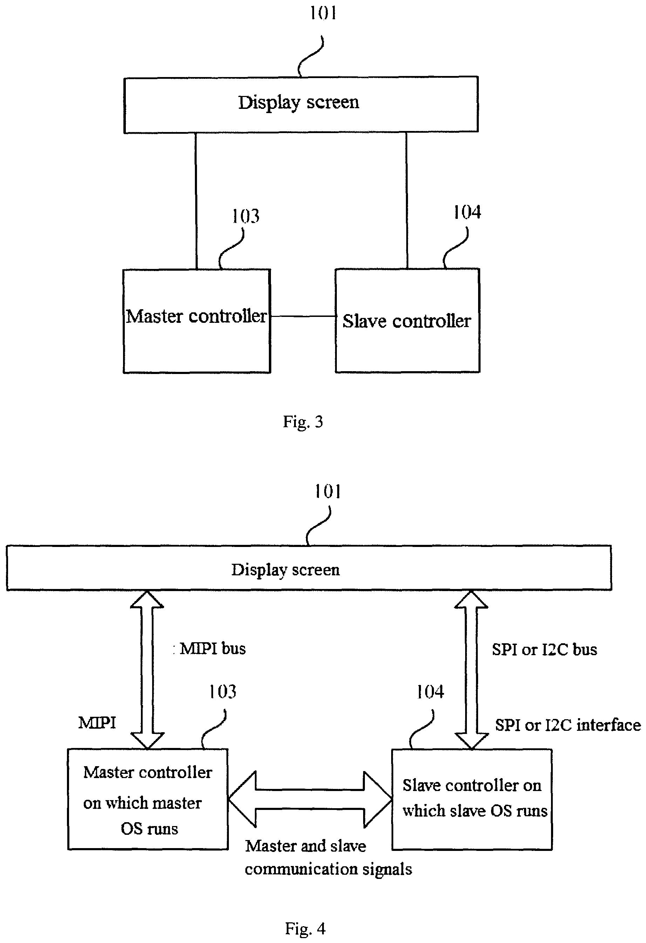

Fig. 3 is a structure diagram of a display device provided by an embodiment 3. This embodiment is formed by modifying the embodiment described above. As shown in Fig. 3, the master controller 103 is connected to the slave controller 104.

The master controller 103 is configured to trigger the slave controller 104 to enter an operating state when the master controller 103 switches from the operating state to a hibernating state and to trigger the slave controller 104 to enter the hibernating state when the master controller 103 switches from the hibernating state to the operating state.

The master controller 103 is connected to the controller 104. When the master controller 103 switches between states, the master controller 103 triggers the slave controller 104 to switch between states at the same time. In an embodiment, when the master controller 103 on which the master operating system runs switches from the operating state to the hibernating state, the master controller 103 triggers the slave controller 103 to enter the operating state. When the slave controller 104 on which the slave operating system runs switches from the hibernating state to the operating state and starts controlling the display screen 101 to display, the master controller 103 stop controlling the display screen 101 to display. When the master controller 103 on which the master operating system runs switches from the hibernating state to the operating state, the master controller 103 triggers the slave controller 104 to enter the hibernating state. When the slave controller 104 on which the slave operating system runs switches from the operating state to the hibernating state, the slave controller 104 stops controlling the display screen 101 to display, and the master controller 103 starts controlling the display screen 101 to display. Based on the requirements of the display device, the master controller 103 switches between states, and the master controller 103 on which the master operating system runs does not stay in the operating state, reducing the consumption of the battery power and extending the stand-by time of the display device. When the master controller 103 switches between states, the master controller 103 triggers the slave controller 104 to switch between states at the same time. This guarantees the stability and accuracy of the switch of the states of the master controller 103 and the slave controller 104, and improves the stability of the display device. Fig. 4 is a structure diagram of a display device provided by an embodiment 3. Optionally, as shown in Fig. 4, the master controller 103 is connected to the display screen 101 through the MIPI, the slave controller 104 is connected to the display screen 101 through the SPI or the I2C interface. A master operating system runs on the master controller. A slave operating system runs on the slave controller. The master controller 103 and the slave controller 104 are connected and deliver information to each other via master and slave communication signals. For the display device provided by the embodiment, operating systems with different power consumption respectively run on the master controller and the slave controller, the master controller and the slave controller switch their states according to the requirements of the display device, and control the display screen to display. When the master controller switches between states, the master controller triggers the slave controller to switch between states at the same time. This addresses the problem in the related art that, in the case where the operating system is the only system for driving the screen to display and is complex, the operating system of the display device needs to stay in the operating state and the display screen cannot be controlled flexibly, thereby satisfying the requirements on display and flexibly controlling the display screen.

### Embodiment 4

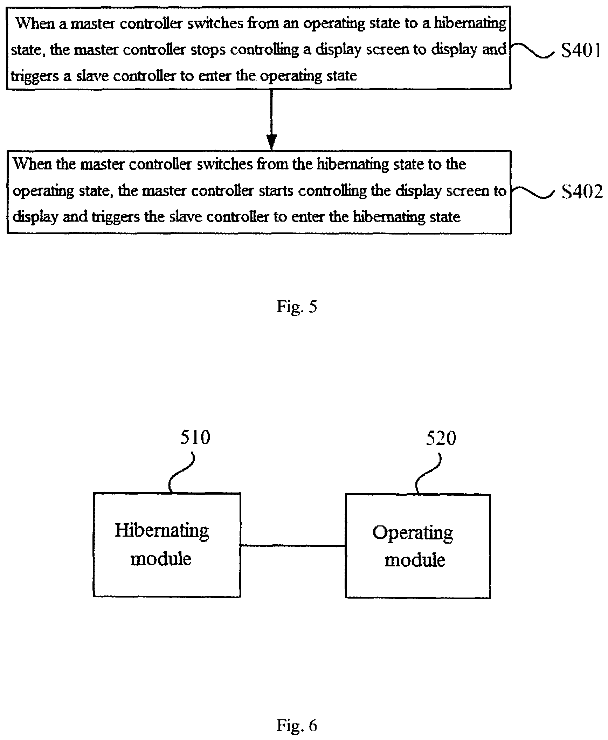

Fig. 5 is a flow chart of a method of controlling screen display provided by an embodiment 4. The present embodiment applies to the case where the requirements on display of the user is satisfied and the display screen is controlled flexibly. As shown in Fig. 5, the method includes a step 410 and a step 420.

In step 410, when a master controller switches from an operating state to a hibernating state, the master controller stops controlling a display screen to display and triggers a slave controller to enter the operating state.

A master operating system runs on the master controller, a slave operating system runs on the slave controller, and power consumption of the slave operating system is lower than power consumption of the master operating system. The master controller and the slave controller switch their states according to the requirements of the display device and control the display screen to display. The states of the master controller and the slave controller include operating state and hibernating state. The master controller and the slave controller switch their states according to the requirements of the display device and control the display screen to display. For illustration and not for limitation, when the touch screen of the display screen does not receive information from the user within a preset time, or when the display device is in the sport mode or the charging mode, the master controller switches from the operating state to the hibernating state. Or, when the touch screen receives touch information of the user, the master controller switches from the hibernating state to the operating state.

The master controller is connected to the slave controller. When the master controller switches between states, the master controller triggers the slave controller to switch at the same time. In an embodiment, when the master controller on which the master operating system runs switches from the operating state to the hibernating state, the master controller stops controlling the display screen to display and triggers the slave controller to enter the operating state. The slave controller on which the slave operating system runs switches from the hibernating state to the operating state and starts controlling the display screen to display.

Optionally, after the master controller triggers the slave controller to enter the operating state, the method further includes:
the master controller sends basis information to be displayed to the slave controller; the basic information to be displayed is information displayed by the display screen in the control of the slave controller after the slave controller enters the operating state.

The basic information to be displayed includes at least one of the followings: system time, system date, and data on vital signs (e.g., heartbeat or blood pressure in the sport state).

In an embodiment, when the master controller on which the master operating system runs switches from the operating state to the hibernating state, the master controller triggers the slave controller to enter the operating state and sends the basis information to be displayed to the slave controller. The slave controller on which the slave operating system runs switches from the hibernating state to the operating state, receives the basic information to be displayed from the master controller and controls the display screen to display the basic information to be displayed.

In step 420, when the master controller switches from the hibernating state to the operating state, the master controller starts controlling the display screen to display and triggers the slave controller to enter the hibernating state.

When the master controller on which the master operating system runs switches from the operating state to the hibernating state, the master controller starts controlling the display screen to display and triggers the slave controller to enter the operating state. The slave controller on which the slave operating system runs switches from the hibernating state to the operating state and stops controlling the display screen to display. The master controller switches between states according to the requirements of the display device. When the master controller switches between states, the master controller triggers the slave controller to switch between states at the same time. This guarantees the stability and accuracy of the switch of the states of the master controller and the slave controller, and improves the stability of the display device.

When the master controller switches from the hibernating state to the operating state, the master controller stops controlling the display screen to display, and when the master controller switches from the operating state to the hibernating state, the master controller starts controlling the display screen to display.

Optionally, the step in which the master controller stops controlling the display screen to display includes that the master controller closes a display driver of the master controller.
the step of using the master controller to start controlling the display screen to display comprises: using the master controller to open the display driver of the master controller.

The master controller uses the its display driver to control the display screen to display.

Optionally, the step in which the slave controller stops controlling the display screen to display includes that the slave controller closes a display driver of the slave controller; and the step in which the slave controller starts controlling the display screen to display includes that the slave controller opens the display driver of the slave controller. The slave controller uses the its display driver to control the display screen to display.

For the method of controlling screen display provided by the embodiment, the master controller and the slave controller switches their states according to the requirements of the display device and control the display screen to display. When the master controller switches between states, the master controller triggers the slave controller to switch between states at the same time. This addresses the problem in the related art that, in the case where the operating system is the only system for driving the screen to display and is complex, the operating system of the display device needs to stay in the operating state and the display screen cannot be controlled flexibly, thereby satisfying the requirements on display and flexibly controlling the display screen.

### Embodiment 5

Fig. 6 is a structure diagram of a device of controlling screen display provided by an embodiment 5. As shown in Fig. 6, the device includes:
a hibernating module 510 and an operating module 520.

The hibernating module 510 is configured to, when a master controller switches from an operating state to a hibernating state, stop controlling a display screen to display and trigger a slave controller to enter the operating state. The operating module 520 is configured to, when the master controller switches from the hibernating state to the operating state, start controlling the display screen to display and trigger the slave controller to enter the hibernating state. When the slave controller switches from the hibernating state to the operating state, the master controller stops controlling the display screen to display. When the slave controller switches from the operating state to the hibernating state, the master controller starts controlling the display screen to display.

For the device of controlling screen display provided by the embodiment, the master controller and the slave controller switches their states according to the requirements of the display device and control the display screen to display. When the master controller switches between states, the master controller triggers the slave controller to switch between states at the same time. This addresses the problem in the related art that, in the case where the operating system is the only system for driving the screen to display and is complex, the operating system of the display device needs to stay in the operating state and the display screen cannot be controlled flexibly, thereby satisfying the requirements on display and flexibly controlling the display screen.

On the basis of the embodiments described above, the hibernating module 510 may include a driver closing unit. The driver closing unit is configured to close the display driver of the master controller.

The operating module 520 may include a driver opening unit. The driver opening unit is configured to open the display driver of the master controller.

On the basis of the embodiments described above, the hibernating module 520 may further include:
an information sending unit, which is configured to send basic information to be displayed to the slave controller; the basic information to be displayed is information displayed by the display screen in the control of the slave controller after the slave controller enters the operating state.

The basic information to be displayed includes at least one of the followings: system time, system date, and data on vital signs.

The device of controlling screen display provided by the embodiment can implement the method of controlling screen display provided by any embodiment, having corresponding function modules required for implementing the method and the effects.

### Embodiment 6

The embodiment further provides a computer readable storage medium. A computer program is stored on the computer readable storage medium and is executed by a processor to implement the method of controlling screen display provided by the embodiment.

The computer storage medium of the present embodiment may one computer readable medium or a combination of any computer readable mediums. The computer readable medium may be a computer readable signal medium or a computer readable storage medium. The computer readable storage medium for example may be, but not limited to, a system, a device or a component of any type of electric, magnet, light, electromagnet, infrared or semiconductor, or any combination thereof. The specific examples (but not an exhaustive list) of the computer readable storage medium include: electrical connection with one or more wires, portable computer magnetic disk, hard disk, random access memory (RAM), read-only memory (ROM), erasable programmable read-only memory (EPROM, or flash), optical fiber, compact disk read-only memory (CD-ROM), optical storage device, magnetic storage device, or any combination thereof. Herein, the computer readable storage medium may be any physical medium containing or storing the program, which may be executed by an instruction execution system, device, component or the combination thereof.

The computer readable signal medium may include data signals which are transmitted in the baseband or are transmitted as part of carriers. The data signals carry computer readable program codes. The data signals transmitted in such way may have various forms, which include, but not limited to, magnetic signals, optical signals or any proper combination thereof. The computer readable signal medium may also be any computer readable medium other than the computer readable storage medium. The computer readable medium may send, transmit or transfer the program which is used by or in combination with the instruction execution system, device or component.

The program codes on the computer readable medium may be transferred by means of the medium of any types, which includes, but not limited to, wireless, wire, cable and radio frequency (RF), or any proper combination thereof.

The computer program codes for implementing the embodiment may be edited in one or more programming languages, or a combination thereof. The programming languages include object-oriented programming languages (e.g., Java, Smalltalk, C++) and process-oriented programming languages (e.g., C language or the like). The program codes may be executed in one of the following manners: all the program codes are executed on a computer of the user, part of the program codes is executed on the computer of the user, the program codes are executed as an independent software package, a part of the program codes is executed on the computer of the user and the other part is executed on a remote computer, all the program codes are executed on the remote computer or a server. In the case where a remote computer is used, the remote computer may be connected to the user computer through a network of any types, including local area network (LAN) and wide area network (WAN), or may be connected to an external computer, e.g., through Internet provided by an Internet service provider.

### Embodiment 7

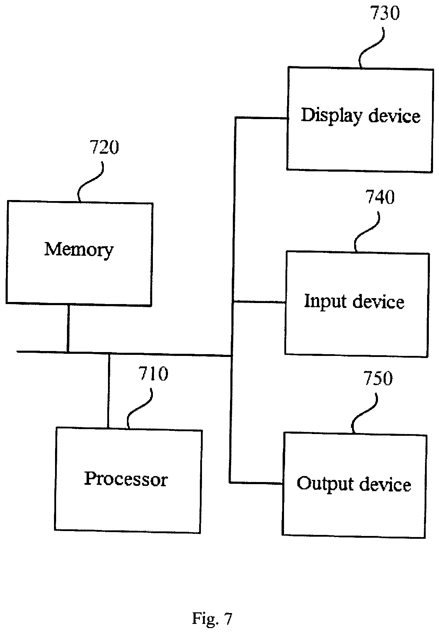

Fig. 7 is a structure diagram of an electronic device provided by an embodiment 7. As shown in Fig. 7, the electronic device includes a processor 710, a memory 720, a display device 730, an input device 740 and an output device 750. The electronic device may includes one or more processors 710. Fig. 7 is an example in which one processor 710 is used. The processor 710, the memory 720, the display device 730, the input device 740 and the output device 750 may be connected to each other through a bus or in other manners. Fig. 7 is an example in which a bus is used.

The memory 720, which is a computer readable storage medium, may be used to store a software program, a computer executable program and modules, e.g., program codes/modules corresponding to the method of controlling screen display of the embodiment, such as the hibernating module 510 and the operating module 520 of the device for controlling screen display. The processor 710 executes the software program, instructions and modules stored in the memory 720 to implement various function applications and data processing on the electronic device.

The memory 720 mainly includes a program storage region and a data storage region. The program storage region may store the operating system and the application program required for at least one function. The data storage region may store the data which are created in the use of the terminal. In addition, the memory 720 may include a high-speed random access memory and may also include a non-volatile memory, e.g., at least one magnetic memory device, flash memory device or any other non-volatile solid state memory device. In some embodiments, the memory 720 may further include a memory which is remote from the processor 710. This memory may be connected to the electronic device through the network. The network may be, but not limited to, Internet, intranet, LAN, mobile communication network or the combination thereof.

The display device 730 may include the display device provided by the embodiment.

The input device 740 may be used to receive inputted number or character information, and generate a key signal input related to the user settings and function control of the electronic device. The output device 750 may include a voice player.

Optionally, the electronic device is a smartwatch or a smart bracelet.

In general, a battery of a wearable device such as smartwatch or smart bracelet has a small size and thus a small capacity. The shortage of such wearable device is the short stand-by time. In the wearable device described herein, multiple processors on which operating system with different power consumption are used. As such, the battery time of the device is significantly extended and the user experience is apparently improved.

### Industrial applicability

The present disclosure provides a display device. The display device addresses the problem in the related art that, in the case where the operating system is the only system for driving the screen to display and is complex, the operating system of the display device needs to stay in the operating state and the display screen cannot be controlled flexibly, thereby achieving the effects of satisfying the requirements on display and flexibly controlling the display screen.

## Claims

1. A display device, comprising: a display screen and at least two controllers,
at least two types of operating systems respectively run on the at least two controllers,
the at least two controllers are respectively connected to the display screen through at least two types of interfaces, and the at least two controllers each is configured to, in a respective operating state, control the display screen to display.

2. The display device according to claim 1, wherein the controllers include a master controller and a second controller,
a master operating system runs on the master controller, a slave operating system runs on the slave controller, and power consumption of the slave operating system is lower than power consumption of the master operating system.

3. The display device according to claim 2, wherein the master operating system includes an Android operating system, and the slave operating system includes a real-time operating system.

4. The display device according to claim 2, wherein the master controller is connected to the display screen through a mobile industry processor interface, the slave controller is connected to the display screen through a serial peripheral interface or an inter-integrated circuit interface.

5. The display device according to claim 4, wherein the master controller is connected to the slave controller,
the master controller is configured to trigger the slave controller to enter an operating state when the master controller switches from the operating state to a hibernating state and to trigger the slave controller to enter the hibernating state when the master controller switches from the hibernating state to the operating state.

6. The display device according to any of claims 1 to 4, wherein the display screen includes an organic light emitting display panel and a touch screen covering the organic light emitting display panel.

7. An electronic device, comprising a display device according to any of claims 1 to 6.

8. A method of controlling screen display, comprising:
when a master controller switches from an operating state to a hibernating state, using the master controller to stop controlling a display screen to display and trigger a slave controller to enter the operating state; and
when the master controller switches from the hibernating state to the operating state, using the master controller to start controlling the display screen to display and trigger the slave controller to enter the hibernating state,
wherein when the slave controller switches from the hibernating state to the operating state, the slave controller stops controlling the display screen to display, and when the slave controller switches from the operating state to the hibernating state, the slave controller starts controlling the display screen to display.

9. The method according to claim 8, wherein the step of using the master controller to stop controlling the display screen to display comprises: using the master controller to close a display driver of the master controller,
the step of using the master controller to start controlling the display screen to display comprises: using the master controller to open the display driver of the master controller.

10. The method according to claim 8, wherein after the master controller triggers the slave controller to enter the operating state, the method further comprises:
using the master controller to send basic information to be displayed to the slave controller, wherein the basic information to be displayed is information displayed by the display screen in the control of the slave controller after the slave controller enters the operating state,
wherein the basic information to be displayed includes at least one of the followings: system time, system date, and data on vital signs.
